# EUROPÄISCHE PATENTANMELDUNG

(11) **EP 2 226 816 A1**
(43) Veröffentlichungstag der Anmeldung: **08.09.2010**
(21) Anmeldenummer: 09001052.1
(22) Anmeldetag: 27.01.2009
(51) Int. Cl.: H01F 27/02, H01F 38/30, H01F 41/00, G01R 15/20

(54) **Stromwandler und dessen Herstellverfahren für die Messung und den Schutz in Hoch- und Mittelspannungsnetzen**

(71) Anmelder: Siemes, Andreas, 47661 Issum (DE)
(72) Erfinder: Siemes, Andreas, 47661 Issum (DE)
(74) Vertreter: Flaig, Siegfried

(57) **Zusammenfassung**

Es wird ein Stromwandler (1) und dessen Herstellverfahren für die Messung und den Schutz in Hoch- oder Mittelspannungsnetzen vorgeschlagen, wobei die Messung des Stroms an einer Stromschiene (2) stattfindet, und der Stromwandler (1) jeweils im oberen Bereich (8) eines Kopfes (1 a) einen Magnetfeldsensor (5) aufweist, und einen unteren Bereich (10) mit einer Auswerte-Elektronik auf einer Platine (12), die an der Eingangsöffnung (17) einen leicht zugänglichen Erdungsanschluss (13), einen DIP-Schalter (19), ein Potentiometer (18) zur Feinabstimmung und eine Einsteckbuchse (6a) mit Stecker (6) besitzt und zwei miteinander verbundene Gehäuse-Hälften (14a, 14b) mittels Gießharz im Inneren ausgefüllt sind.

## Beschreibung

Die Erfindung betrifft einen Stromwandler und dessen Herstellverfahren für die Messung und den Schutz in Hoch- oder Mittelspannungsnetzen, wobei die Messung des Stroms an einer Stromschiene stattfindet, und der Stromwandler jeweils im Bereich eines Kopfes mit Abstand von einem nicht geschlossenen Ring aus magnetisch leitfähigem Werkstoff umgeben ist, der im Spalt zwischen offenen Enden des Rings einen Magnetfeldsensor aufweist, wobei die Anschlussleitungen des Magnetfeldsensors mit einer Messschaltung verbunden sind.

Die eingangs bezeichnete Gattung ist aus der DE 101 34 014 A1 bekannt. Eine ähnliche Messeinrichtung für optische Messwandler ist ferner aus der DE 41 00 054 C2 bekannt. Ferner wird in der DE 10 2004 038 847 B3 ein mehrlagiger Aufbau in LTCC-Technologie der Strommesseinrichtung beschrieben.

Als Primärsignal werden etwa 0 - 10 000 Ampere durch die Stromschiene geleitet und vom Stromwandler gemessen. In einem Sekundärkreis gibt der Stromwandler ein Signal von etwa 0 - 4 Volt proportional zum Primärsignal ab. Solche Stromwandler werden in Schaltschränken für hohe Leistungen eingesetzt. Dabei schreibt die IEC-Norm unterschiedliche Abstände zwischen dem spannungsführenden Leiter und dem Erdpotential vor. Bspw. gelten für 7,2 kV = 90 mm Abstand und für 12 kV 120 mm. Der Erdabstand der Stromschiene wird üblicherweise mit ca. 130 mm ausgeführt. Zu beachten ist außerdem, dass eine Bewegung der Kupferschiene aus einem nicht erkennbaren Grund oder wenn die Stromschiene kurzzeitig einen Kurzschlussstrom führt oder aus anderen Gründen keine Beschädigung der Strommesseinrichtung erzeugen darf. Der Abstand zwischen Kupferschiene und Erde wird außerdem mittels aufeinanderfolgenden Rippen zur Vermeidung von Kriechströmen durch Staubablagerungen vergrößert.

Nach dem Stand der Technik ( DE 101 34 014 A1 ) werden die Anschlussleitungen des Magnetfeldsensors durch die Stützisolatoren hindurch bis zum Ausgang des Stromwandlers geführt und enden dann in peripheren Einrichtungen. Dadurch entsteht ein höherer Platz- und Raumbedarf und erhöht sich die Gefahr einer Fehlmessung und anderer Störfaktoren, die unbedingt zu vermeiden sind.

Der Erfindung liegt die Aufgabe zugrunde, eine verbesserte Verbindung der Messsensorik mit dem Magnetfeldsensor zu schaffen, um dadurch eine Erhöhung der Sicherheit der Messung und die Vermeidung weiterer Störfaktoren zu erzielen, wobei eine Raumersparnis angestrebt wird. Gleichzeitig soll das Herstellverfahren im Sinn einer sicher funktionsfähigen Einheit verbessert werden.

Diese Aufgabe löst die Erfindung dadurch, dass in einem oberen Bereich die Stromschiene durch einen dem Querschnitt der Stromschiene anpassbaren Öffnungskanal mit Spiel verläuft, dessen Kanalwandung den Ring aus magnetisch leitfähigem Werkstoff gegenüber der Stromschiene isoliert und dass in einem unteren Bereich, an dem sich außen die Kriechstromschutz-Rippen befinden, im Inneren zumindest eine Platine mit einer Auswerte-Elektronik und ein Erdungsanschluss angeordnet sind, wobei das aus Gießharz bestehende Gehäuse aus zwei Gehäuse-Hälften, die dicht miteinander verbindbar sind, besteht und wobei die Gehäusehälften mittels zumindest einem in den Dichtflächen vorgesehenen Passloch und einem gegenüberliegenden Passstift zueinander ausrichtbar und beide Gehäusehälften im verbundenen Zustand mittels Gießharz im Inneren (weitestgehend ohne kleinste Luftblasen) ausgefüllt sind. Dadurch entsteht ein kompaktes, elektrisch sicheres Gehäuse, das mit dem zu messenden Stromleiter auf kürzestem Weg über die Messschaltung bzw. mit der Auswerte-Elektronik verbunden ist und dadurch keine Grundlage für Fehlmessungen oder Störfaktoren bilden kann. Es kann eine leichte und sichere Montage des zum Sekundärkreis gehörenden Rings aus magnetisch leitfähigem Werkstoff ermöglicht werden. Außerdem werden eine Raumersparnis und eine leichtere Hand habung erzielt. Die Herstellung und die Montage werden gleichermaßen begünstigt. Die Vorteile sind die nach außen völlig abgeschirmte Einheit und der nach außen fertige Abschluss der elektrischen Bauteile, die somit den einschlägigen Sicherheitsanforderungen entspricht.

Die Anordnung und Unterbringung des Magnetfeldsensors und des nicht geschlossenen Rings aus magnetisch leitfähigem Werkstoff werden in einem gesondert geschaffenen Raum vorgenommen, der dahingehend gestaltet ist, dass der Öffnungskanal mit der Kanalwandung einen schachtförmigen Vorsprung bildet, der zur Trenn-Ebene der beiden Gehäusehälften sich ergänzend jeweils einen unterschiedlichen Abstand zur Trenn-Ebene aufweist, so dass nach Montage beide Stirnflächen und die Trenn-Ebenen dicht aufeinanderliegen. Dadurch wird eine ausreichend große Durchgangslänge der Stromschiene gewonnen.

Zur genaueren Messung des Magnetfeldes ist vorgesehen, dass der Ring aus magnetisch leitfähigem Werkstoff gegenüberliegend am Umfang einfach oder doppelt mit offenen Enden versehen und jeweils mit zwischen diesen befindlichen Magnetfeldsensoren bestückt ist.

Das Gehäuse weist nach weiteren Merkmalen im Inneren einen oberen Bereich für den Magnetfeldsensor und einen unteren Bereich für die Platine mit der Auswerte-Elektronik auf, die durch zumindest einen Quersteg, der in der Trenn-Ebene liegt, getrennt sind, wobei Verbindungsleitungen durch den Quersteg hindurch verlegt sind, die den Magnetfeldsensor mit der Platine für die Auswerte-Elektronik verbinden. Dadurch wird eine Verstärkung im Sinn einer Versteifung des Gesamtgehäuses u.a. für mechanische Beanspruchungen geschaffen. Außerdem wird die Verbindung mit dem Magnetfeldsensor von außen durch Anschlüsse für mehrere Funktionen ergänzend erweitert.

In diese Richtung weisen mehrere Funktionen hin, nämlich dass auf der Platine für die Auswerte-Elektronik an der Eingangsöffnung der verbundenen Gehäusehälften ein Erdungsanschluss, ein DIP-Schalter zur Messbereichs-Vorwahl, eine Einsteckbuchse für einen Stecker und ein Potentiometer für die Feinabstimmung vorgesehen sind.

Durchschlagsicherheit und mechanische Stabilität werden dadurch erreicht, dass die Mindestdicke des Gehäuses und / oder der Kanalwandung und / oder des Querstegs ca. 4 mm beträgt.

Eine weitere mechanische Verstärkung des Stromwandlers kann dadurch erzielt werden, dass die Gehäusehälften um die Eingangsöffnung einen Flansch bilden, in dem Gewinde für Befestigungsschrauben angeordnet sind. Gleichzeitig dient der Flansch als größere Auflagefläche für eine entsprechend große Befestigungsfläche.

Weiterhin wird ein Verfahren zum Herstellen eines Stromwandlers für die Potentialtrennung zwischen Mittel- oder Hochspannung, einer Messschaltung bzw. Auswerte-Elektronik und dem Erdpotential vorgeschlagen, die in einem Gehäuse aus Gießharz eingebaut sind, und mit folgenden Schritten ausgeführt werden:
1. Zwei Gehäusehälften werden aus Gießharz gegossen,
2. in einer der Gehäusehälften werden ein Magnetfeldsensor und eine Platine mit einer Auswerte-Elektronik fertig montiert und elektrisch miteinander verschaltet,
3. die beiden Gehäusehälften werden dicht aufeinander geklebt,
4. das Innere des fertig montierten Stromwandlers, der mit der Eingangsöffnung nach oben gestellt wird, wird evakuiert,
5. in das Innere des evakuierten Stromwandlers wird flüssiges Gießharz eingefüllt bis die Eingangsöffnung nur noch die Anschlussleitungen für die Auswerte-Elektronik, die Einsteckbuchse, einen Erdungsanschluss, ein Potentiometer zur Feinabstimmung und einen DIP-Schalter freihält,
6. die verbundenen Gehäusehälften werden nach dem Erkalten als fertige Einheit entnommen.

Damit ist eine elektrisch sichere und mechanisch beanspruchbare Ausführungsform des Stromwandlers geschaffen.

Um alle technischen Variationen der Evakuierung möglich zu machen, ist noch vorgesehen, dass der fertig montierte Stromwandler in einer Vakuumkammer evakuiert wird. Dabei kann nach Vorhandensein einer solchen Vakuumkammer vorgegangen werden.

Eine weitere Variante der Evakuierung besteht darin, dass das Innere des Stromwandlers durch Abdecken der nach oben gestellten Eingangsöffnung mit einer Deckplatte für Vakuumbehälter evakuiert wird.

In der Zeichnung sind Ausführungsbeispiele der Erfindung dargestellt , die nachstehend näher erläutert werden. Es zeigen:
- Fig. 1 A: eine perspektivische Ansicht der die elektrischen Bauteile aufnehmenden Gehäusehälfte,
- Fig. 1 B: eine in der Ebene plane Draufsicht auf diese Gehäusehälfte,
- Fig. 2: eine perspektivische Ansicht des fertigen, aus den beiden zusammen geklebten Gehäusehälften gebildeten Stromwandlers,
- Fig. 3: einen Querschnitt durch den Stromwandler in Höhe der Platine,
- Fig. 4: eine Vorderansicht auf den fertigen Stromwandler aus zwei Gehäusehälften,
- Fig. 5: eine Außenansicht des Stromwandlers,
- Fig. 6: die zu Fig. 5 gehörige Seitenansicht,
- Fig. 7: eine perspektivische Ansicht des für die Evakuierung vorbereiteten Stromwandlers, der im Inneren noch hohl ist und nur durch die bezeichneten Bauteile belegt ist und
- Fig. 8: eine mögliche Stellung des Stromwandlers während des Evakuierens bzw. Befüllens.

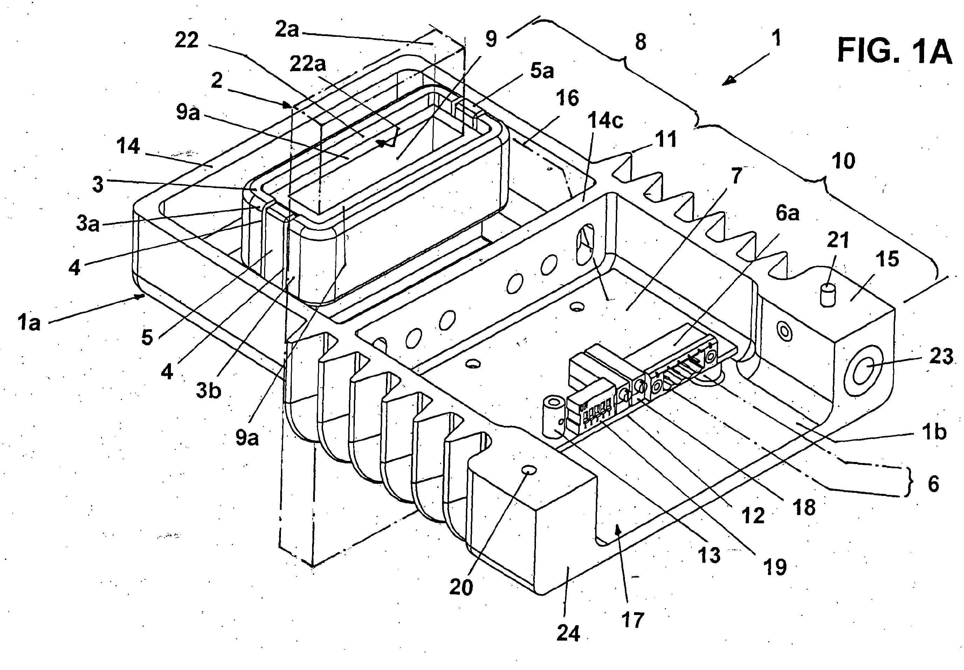

In Fig. 1A ist der Stromwandler 1 mit einem Kopf 1 a versehen, durch den die Stromschiene 2 mit Spiel von bspw. 1 mm verläuft. In einem oberen Bereich 8 befindet sich ein dem Querschnitt 2a der Stromschiene 2 angepasster Öffnungskanal 9, dessen Kanalwandung 9a den nicht geschlossenen, aus magnetisch leitfähigem Werkstoff gefertigten Ring 3 im Inneren auskleidet, wobei auf beiden Seiten ein offenes Ende 3a und ein offenes Ende 3b bestehen und ein Spalt 4 zwischen den Enden 3a, 3b und einem Magnetfeldsensor 5 vorhanden ist. Im Ausführungsbeispiel wird als Magnetfeldsensor 5 ein Hall-Sensor 5a eingesetzt. In einem unteren Bereich 10, an dem außen Kriechstromschutz-Rippen 11 angeformt sind, sind im Inneren 1 b zumindest eine Platine 12 mit einer Auswerte-Elektronik vorgesehen. Diese ist schaltungsmäßig nicht Gegenstand der Erfindung. Die Auswerte-Elektronik 12 besteht aus einer Messschaltung 7, die die Signale des Hall-Sensors 5a verarbeitet. Auf der Platine 12 befindet sich außerdem ein Erdungsanschluss 13 und eine Einsteckbuchse 6a.

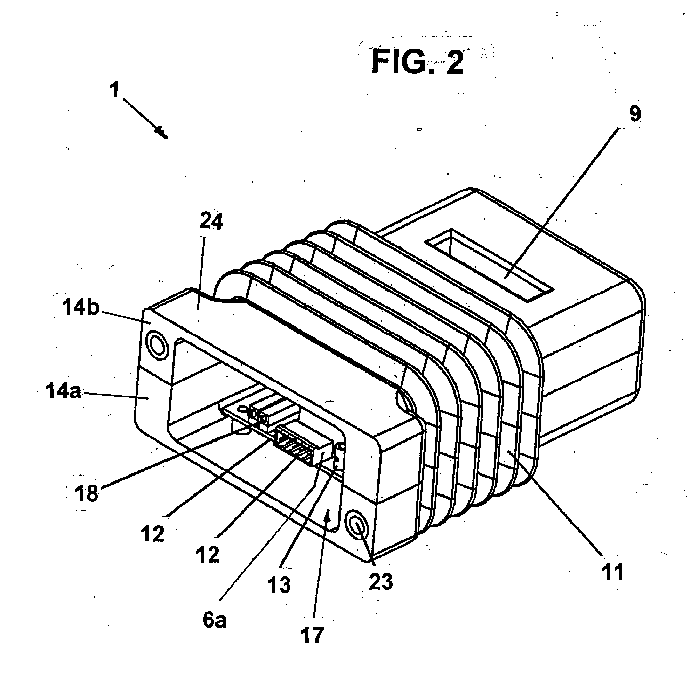

Das aus Gießharz bestehende Gehäuse 14 ist aus zwei ggf. formgleichen Gehäuse-hälften 14a und 14b zusammengesetzt (Fig.2, 5 und 6). Die beiden symmetrischen Gehäusehälften 14a und 14b werden in der Trenn-Ebene 15 mittels Klebstoff dicht aufeinander gelegt und dauerhaft verklebt. Dabei richten zumindest ein in der Dichtfläche vorgesehenes Passloch 20 und ein gegenüberliegender Passstift 21 die Gehäusehälften 14a, 14b genau zueinander aus.

Im oberen Bereich 8 bildet der Öffnungskanal 9 mit der Kanalwandung 9a, die zumindest 4 mm dick ist, einen schachtförmigen Vorsprung 22, der im Ausführungsbeispiel vor der Trenn-Ebene 15 der beiden Gehäusehälften 14a, 14b endet oder übersteht. Im Ausführungsbeispiel ist der Ring 3 aus magnetisch leitfähigem Werkstoff, wie bspw. Eisen, gegenüberliegend am Umfang doppelt mit offenen Enden 3a, 3b versehen und jeweils mit zwischen diesen befindlichen Magnetfeldsensoren 5, wie bspw. Hall-Sensoren 5a bestückt. Die Magnetfeldsensoren 5 sind mittels Verbindungsleitungen 16 durch einen Steg 14c hindurch mit der Platine 12 verbunden. In dem Steg 14c befinden sich weitere Öffnungen, die den Durchtritt von Füll- und Isolierwerkstoffen bei der Verbindung der beiden Gehäusehälften 14a, 14b ermöglichen.

Die Anordnung des oberen Bereichs 8 und des unteren Bereichs 10 ermöglicht auch den Zugriff auf weitere Funktionen des Stromwandlers. So sind auf der Platine 12 für die Auswerte-Elektronik an der Eingangsöffnung 17 ein Potentiometer 18 zur Feinabstimmung und ein DIP-Schalter 19 ( zur Messbereichsvorwahl) und eine Einsteckbuchse 6a für einen (nicht dargestellten) Stecker 6 sowie der Erdungsanschluss 13 nebeneinander angeordnet, so dass alle Anschlüsse von außen erreicht werden können. Die Einsteckbuchse 6a für den Stecker 6 ist auf der Platine 12 wie beschrieben neben den übrigen Bauteilen angeordnet ( Fig. 2).

Die Stromschiene 2 mit dem während des Stromflusses erzeugten räumlichen Magnetfeld bildet einen Primärkreis.
Der Sekundärkreis besteht aus dem nicht geschlossenen Ring 3 aus magnetisch leitfähigem Werkstoff mit den offenen Enden 3a, 3b und dem Spalt 4 des Ringes 3, mit dem Magnetfeldsensor 5, der Einsteckbuchse 6a für den Stecker 6, der Messschaltung 7, den Verbindungsleitungen 16, dem Potentiometer 18 zur Feinabstimmung, dem Erdungsanschluss 13 und dem DIP-Schalter 19.

Die Gehäusehälften 14a, 14b bilden einen Flansch 24 mit in Längsrichtung des Stromwandlers verlaufenden Gewinden 23, so dass nach Fertigstellung der Stromwandler 1 auf einer Haltefläche mit Befestigungsschrauben verschraubt werden kann.

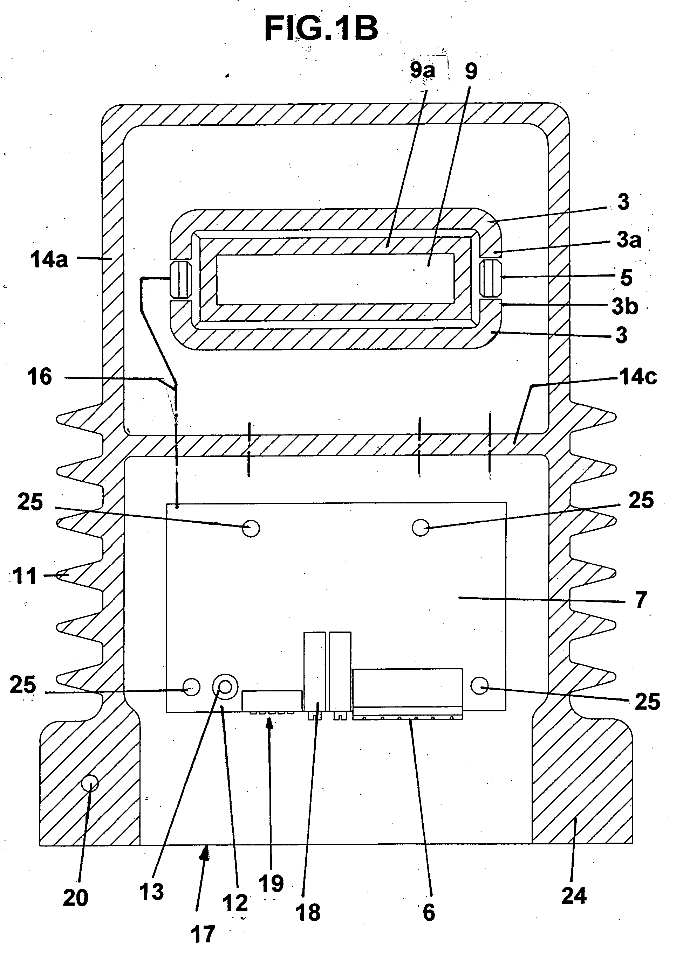

Die Lageverhältnisse, Breiten und Abstände können ohne Verzerrung aus der Fig. 1B entnommen werden. Dabei ist die Befestigung der Platine 12 mit der Messschaltung 7 über ( ggf. an den Gehäusehälften 14a, 14b angegossenen) Gewindepfeiler 25 vorgenommen, die in den vier Ecken der Platine 12 vorgesehen sind.

Die Zugänglichkeit der Elemente an der Eingangsöffnung 17 ist näher in FIG. 2 sichtbar und auch die Anordnung in Variation. So kann der Erdungsanschluss 13 entweder links (FIG. 1A, 1B) oder rechts (FIG. 2) liegen.

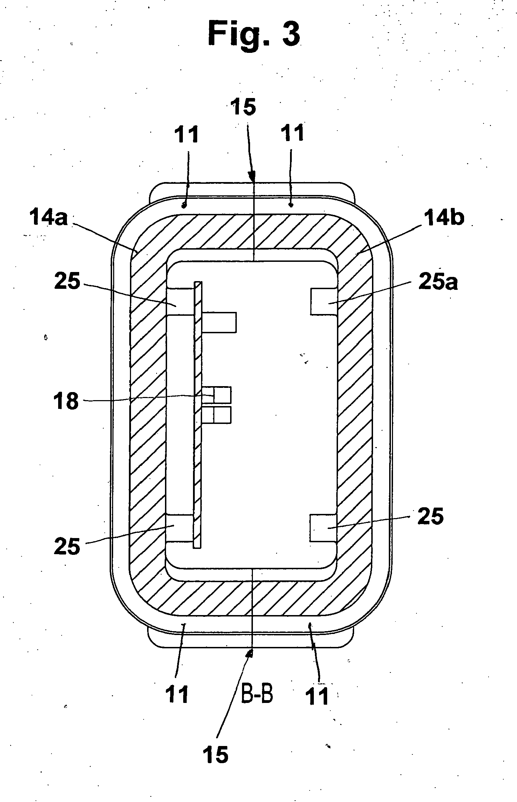

In Fig. 3 ist die Anordnung der Platine 12 auf den erwähnten Gewindepfeilern 25 sichtbar. Diese schaffen zur Gehäusehälfte 14a einen Abstand, der der Höhe der Gewindepfeiler entspricht. Eine Besonderheit liegt in der Erweiterungsmöglichkeit, eine zweite Platine 12 auf der rechten Seite anzuordnen, wozu in Fig. 3 temporär nicht benutzte Gewindepfeiler 25a vorgesehen sind.

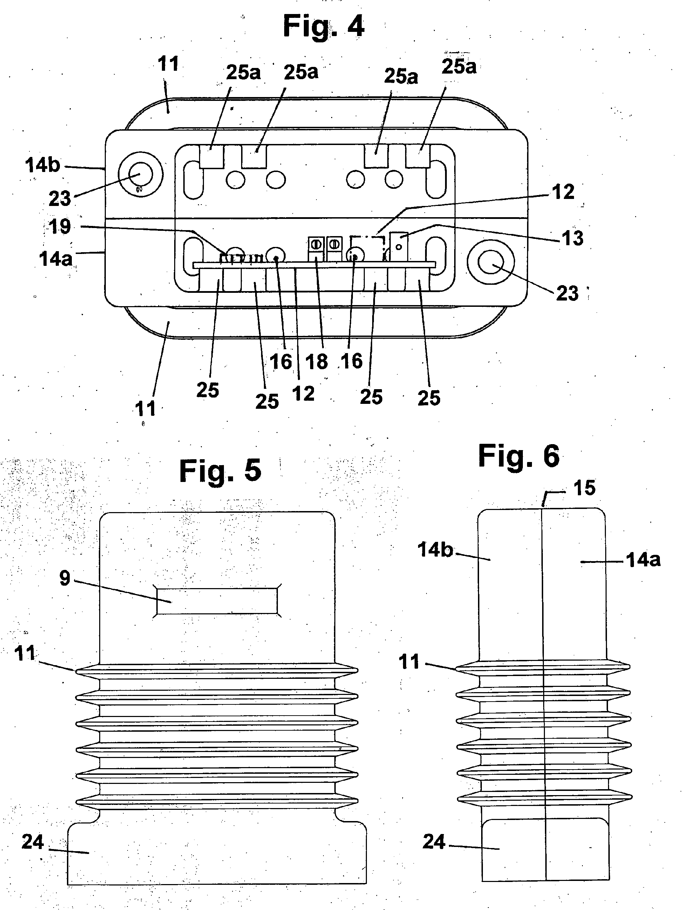

In Fig. 4 ist die Eingangsöffnung 17 von vorne zu sehen. Dabei wird deutlich, dass die beiden Gehäusehälften 14a, 14b gleich sind und nur durch Umschlag in die gezeichnete Lage gelangen, so dass im Grund nur ein Werkzeug zur Herstellung einer Gehäusehälfte 14a oder 14b erforderlich ist. Dabei stört auch nicht die vorhandene Kanalwandung 9a, die etwas zurückgesetzt ist (Fig. 1A), sondern es entsteht eine sichere Führung für die durch zwei Abschnitte verlaufende Stromschiene 2. In FIG. 4 ist im übrigen ebenfalls die zweite Anordnungsmöglichkeit für eine zweite Platine 12 unbesetzt.

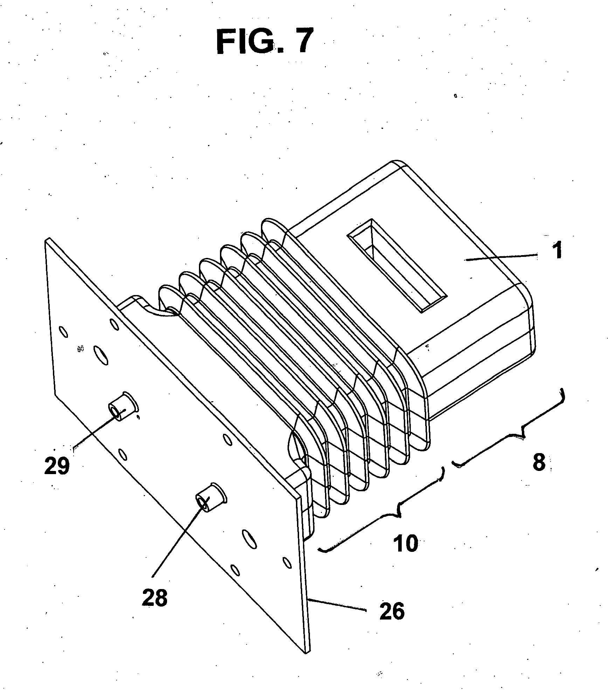

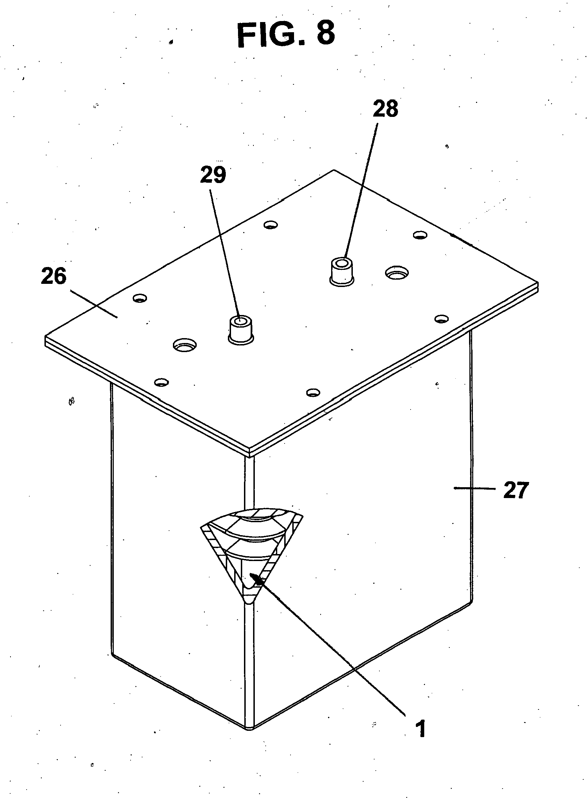

Das Herstellverfahren der in den FIG. 5 und 6 fertigen Stromwandler ist in den FIG. 7 und FIG. 8 gezeigt. Das Verfahren setzt die in den FIG. 1A, 1B, 2, 3 und 4 montierten Bauteile voraus, so dass noch die Isolation im Innern der Gehäusehälften 14a, 14b aussteht. Es sind die folgenden Verfahrensschritte auszuführen:
1. Zwei Gehäusehälften 14a, 14b werden aus Gießharz oder anderen hoch isolierenden Werkstoffen gegossen,
2. in einem der Gehäusehälften 14a wird ein Magnetfeldsensor 5 und eine Platine 12 (oder auch zwei Platinen 12) mit einer Auswerte-Elektronik und den an der Eingangsöffnung 17 erwähnten Bauteilen fertig montiert und elektrisch miteinander verschaltet,
3. die beiden Gehäusehälften 14a, 14b werden dicht aufeinander geklebt,
4. das Innere 1 b des fertig montierten Stromwandlers 1, der mit der Eingangsöffnung 17 nach oben gestellt wird (siehe Fig. 7), wird evakuiert. Im Ausführungsbeispiel wird der Stromwandler 1 verschlossen. Dabei wird die Vakuumkammer 27 mit einem Saugstutzen 28 für die Vakuumpumpe und einem Einfüllstutzen 29 für flüssiges Gießharz (oder ein anderer hoch isolierender Werkstoff) versehen,
5. in das Innere 1 b des evakuierten Stromwandlers 1 wird flüssiges Gießharz eingefüllt, wobei der Unterdruck das Gießharz in alle Hohlräume zieht, bis die Eingangsöffnung 17 nur noch Anschlussleitungen 6 für die Auswerte-Elektronik 12, einen Erdungsanschluss 13, die Einsteckbuchse 6a für den Stecker 6, ein Potentiometer 18 zur Feinabstimmung und einen DIP-Schalter 19, sowie den Zugang für den (nicht dargestellten) Stecker freihält,
6. die verbundenen Gehäusehälften 14a, 14b werden nach dem Erkalten (Verfestigen) als fertige Einheit entnommen.

Für das Evakuieren werden mehrere Möglichkeiten vorgeschlagen. Der fertig montierte Stromwandler 1 kann in einer Vakuumkammer 27, die den Stromwandler 1 umschließt, mit Gießharz ausgegossen werden.
Das Innere 1 b des Stromwandlers 1 kann durch Abdecken mittels einer Deckplatte 26 als Vakuumkammer dienen. Dabei sind auf der Deckplatte 26 der Saugstutzen 28 für eine Vakuumpumpe und der Einfüllstutzen 29 für flüssiges Gießharz vorgesehen.

### Bezugszeichenliste

- 1: Stromwandler
- 1 a: Kopf
- 1 b: Inneres
- 2: Stromschiene
- 2a: Querschnitt
- 3: nicht geschlossener Ring aus magnetisch leitfähigem Werkstoff
- 3a: offenes Ende
- 3b: offenes Ende
- 4: Spalt des Rings
- 5: Magnetfeldsensor
- 5a: Hall-Sensor
- 6: Stecker
- 6a: Einsteckbuchse
- 7: Messschaltung
- 8: oberer Bereich des Stromwandlers
- 9: Öffnungskanal
- 9a: Kanalwandung
- 10: unterer Bereich des Stromwandlers
- 11: Kriechstromschutz-Rippe
- 12: Platine mit Auswerte-Elektronik
- 13: Erdungsanschluss
- 14: Gehäuse
- 14a: Gehäusehälfte
- 14b: Gehäusehälfte
- 14c: Steg
- 15: Trenn-Ebene
- 16: Verbindungsleitungen

### Fortsetzung Bezugszeichenliste

- 17: Eingangsöffnung
- 18: Potentiometer zur Feinabstimmung
- 19: DIP-Schalter
- 20: Passloch
- 21: Passstift
- 22: schachtförmiger Vorsprung
- 22a: Stirnfläche
- 23: Gewinde
- 24: Flansch
- 25: Gewindepfeiler
- 25a: Erweiterungs-Gewindepfeiler
- 26: Deckplatte für Vakuumbehälter
- 27: Vakuumkammer
- 28: Saugstutzen für Vakuumpumpe
- 29: Einfüllstutzen für flüssiges Gießharz

## Patentansprüche

1. Stromwandler für die Messung und den Schutz in Hoch- oder Mittelspannungsnetzen, wobei die Messung des Stroms an einer Stromschiene (2) stattfindet, und der Stromwandler (1) jeweils im Bereich eines Kopfes (1 a) mit Abstand von einem nicht geschlossenen Ring (3) aus magnetisch leitfähigem Werkstoff umgeben ist, der im Spalt (4) zwischen offenen Enden (3a, 3b) des Rings (3) einen Magnetfeldsensor (5) aufweist, wobei die Anschlussleitungen (6) des Magnetfeldsensors (5) mit einer Messschaltung (7) verbunden sind, wobei außerdem in einem oberen Bereich (8) die Stromschiene (2) durch einen dem Querschnitt (2a) der Stromschiene (2) anpassbaren Öffnungskanal (9) mit Spiel verläuft, dessen Kanalwandung (9a) den Ring (3) aus magnetisch leitfähigem Werkstoff gegenüber der Stromschiene (2) isoliert und wobei in einem unteren Bereich (10), an dem sich außen die Kriechstromschutz-Rippen (11) befinden, im Inneren (1 b) zumindest eine Platine (12) mit einer Auswerte-Elektronik und ein Erdungsanschluss (13) angeordnet sind und wobei das aus Gießharz bestehende Gehäuse (14) aus zwei Gehäuse-Hälften (14a, 14b), die dicht miteinander verbindbar sind, besteht und wobei die Gehäusehälften (14a, 14b) mittels zumindest einem in den Dichtflächen vorgesehenen Passloch (20) und einem gegenüberliegenden Passstift (21 ) zueinander ausrichtbar und beide Gehäuse-Hälften (14a, 14b) im verbundenen Zustand mittels Gießharz im Inneren ausgefüllt sind.

2. Stromwandler nach Anspruch 1,
**dadurch gekennzeichnet,**
**dass** der Öffnungskanal (9) mit der Kanalwandung (9a) einen schachtförmigen Vorsprung (22) bildet, der zur Trenn-Ebene (15) der beiden Gehäusehälften (14a, 14b) sich ergänzend jeweils einen unterschiedlichen Abstand zur Trenn-Ebene (15) aufweist, so dass nach Montage beide Stirnflächen (22a) und die Trenn-Ebenen (15) dicht aufeinanderliegen.

3. Stromwandler nach Anspruch 1,
**dadurch gekennzeichnet,**
**dass** der Ring (3) aus magnetisch leitfähigem Werkstoff gegenüberliegend am Umfang einfach oder doppelt mit offenen Enden (3a, 3b) versehen und jeweils mit zwischen diesen befindlichen Magnetfeldsensoren (5) bestückt ist.

4. Stromwandler nach den Ansprüchen 1 bis 3,
**dadurch gekennzeichnet,**
**dass** das Gehäuse (14) im Inneren (1 b) einen oberen Bereich (8) für den Magnetfeldsensor (5) und einen unteren Bereich (10) für die Platine (12) mit der Auswerte-Elektronik aufweist, die durch einen Quersteg (14c), der in der Trenn-Ebene (15) liegt, getrennt sind, wobei Verbindungsleitungen (16) durch den Quersteg (14c) hindurch verlegt sind, die den Magnetfeldsensor (5) mit der Platine (12) für die Auswerte-Elektronik verbinden.

5. Stromwandler nach den Ansprüchen 1 und 4,
**dadurch gekennzeichnet,**
**dass** auf der Platine (12) für die Auswerte-Elektronik an der Eingangsöffnung ( 17 ) der verbundenen Gehäusehälften (14a, 14b) zumindest ein Erdungsanschluss (13), ein DIP-Schalter (19) zur Messbereichs-Vorwahl eine Einsteckbuchse (6a) für einen Stecker (6) und ein Potentiometer (18) für die Feinabstimmung vorgesehen sind.

6. Stromwandler nach den Ansprüchen 1 bis 5,
**dadurch gekennzeichnet,**
**dass** die Mindestdicke des Gehäuses (14) und /oder der Kanalwandung (9a) und / oder des Querstegs (14c) ca. 4 mm beträgt.

7. Stromwandler nach Anspruch 1,
**dadurch gekennzeichnet,**
**dass** die Gehäusehälften (14a, 14b) um die Eingangsöffnung (17) einen Flansch (24) bilden, in dem Gewinde (23) für Befestigungsschrauben angeordnet sind.

8. Verfahren zum Herstellen eines Stromwandlers für die Potentialtrennung zwischen Mittel- oder Hochspannung , einer Messschaltung (7) bzw. Auswerte-Elektronik (12), die in einem Gehäuse (14) aus Gießharz eingebaut sind, und dem Erdpotential,
**gekennzeichnet durch folgende Schritte:**
1. Zwei Gehäusehälften (14a, 14b) werden aus Gießharz gegossen,
2. in einer der Gehäusehälften (14a) werden ein Magnetfeldsensor (5) und eine Platine (12) mit einer Auswerte-Elektronik fertig montiert und elektrisch miteinander verschaltet,
3. die beiden Gehäusehälften (14a, 14b) werden dicht aufeinander geklebt,
4. das Innere (1 b) des fertig montierten Stromwandlers (1) wird mit der Ein - gangsöffnung (17) nach oben gestellt evakuiert,
5. in das Innere (1 b) des evakuierten Stromwandlers (1) wird flüssiges Gießharz eingefüllt bis die Eingangsöffnung (17) nur noch die Platine (22) für die Auswerte-Elektronik und die Einsteckbuchse (6a), einen Erdungsanschluss (13), ein Potentiometer (18) für die Feinabstimmung und einen DIP-Schalter (19) freihält,
6. die verbundenen Gehäusehälften (14a, 14b) werden nach dem Erkalten als fertige Einheit entnommen.

9. Verfahren nach Anspruch 8,
**dadurch gekennzeichnet,**
**dass** der fertig montierte Stromwandler (1) in einer Vakuumkammer (27) evakuiert wird.

10. Verfahren nach Anspruch 8 und / oder 9,
**dadurch gekennzeichnet,**
**dass** das Innere (1 b) des Stromwandlers (1) durch Abdecken der nach oben gestellten Eingangsöffnung (17) mit einer Deckplatte (26) für Vakuumbehälter evakuiert wird.
